# FASCICULE DE BREVET EUROPEEN

(11) **EP 1 859 482 B1**
(45) Date de publication et mention de la délivrance du brevet: **17.02.2010**
(21) Numéro de dépôt: 06726230.3
(22) Date de dépôt: 10.03.2006
(51) Int. Cl.: H01L 23/26, B81B 7/00, B81C 1/00

(54) **PROTECTION D'UN GETTER EN COUCHE MINCE**
DÜNNFILM-GETTER-SCHUTZ
THIN FILM GETTER PROTECTION

(30) Priorité: 14.03.2005 FR 0550649
(43) Date de publication de la demande: 28.11.2007
(73) Titulaire: COMMISSARIAT A L'ENERGIE ATOMIQUE, 75015 Paris (FR)
(72) Inventeur: SOURIAU, Jean-Charles, F-38120 Saint Egreve (FR); DELEVOYE, Elisabeth, F-38000 Grenoble (FR); BALERAS, François, F-38450 Saint Georges des Commiers (FR); HENRY, David, F-38240 Meylan (FR)
(74) Mandataire: Poulin, Gérard
(86) Numéro de dépôt international: PCT/FR2006/050206
(87) Numéro de publication internationale: WO 2006/097652

(56) Documents cités:
- WO-A-02/42716
- US-A- 4 426 769
- US-A1- 2003 138 656
- US-A1- 2004 189 195

## Description

### DOMAINE TECHNIQUE

L'invention concerne le domaine du maintien du vide dans des cavités, notamment pour des dispositifs microélectroniques. Plus spécifiquement, l'invention a trait aux éléments de sorption, connus plus communément sous le nom de « getters », présents dans ces cavités.

L'invention se rapporte en particulier aux getters sous forme de couches minces, et elle est relative à un procédé permettant une protection temporaire de ces composés réactifs lors de la fabrication de la cavité, et n'altérant pas leurs propriétés.

L'invention concerne ainsi la mise en place d'un matériau de protection qui réagit lors d'un traitement thermique pour passer d'une forme de zone protectrice recouvrant le getter à un élément séparé de la couche de sorption.

### ÉTAT DE LA TECHNIQUE ANTÉRIEURE

L'encapsulation, ou « packaging », est aujourd'hui une des clefs du développement des microsystèmes, en particulier mécaniques comme les MEMS (pour « *Micro Electro Mechanical Systems* ») ou des détecteurs infrarouges. Par exemple, pour des composants tels que les résonateurs ou les bolomètres non refroidis, il est nécessaire d'isoler le composant dans une cavité sous un vide plus ou moins poussé.

L'encapsulation peut être effectuée individuellement (par puce) dans un boîtier hermétique, ou à l'échelle du substrat (« *Wafer level packaging ») ;* différentes techniques sont utilisées, comme par exemple le report d'un capot par scellement hermétique, ou la fabrication d'une cavité hermétique autour du dispositif par des technologies de dépôt en couche mince. Des techniques de scellement sous vide dans les MEMS sont par exemple présentées dans l'article de Jin Y et coll. : « MEMS Vacuum Packaging Technology and Applications » ; IEEE, Electronics Packaging Technology Conférence 2003 : 301-306.

Pour maintenir le vide dans la cavité pendant la durée de vie du composant, il est usuel d'y ajouter des matériaux qui vont assurer un pompage in *situ* des gaz résiduels, connus sous le nom de matériaux « getters ». De nombreux métaux ont ainsi des propriétés getters : le baryum, le magnésium, l'aluminium, le thorium, le vanadium, *etc.,* et notamment le titane, qui est très couramment utilisé dans les technologies intégrées ; leurs performances sont bien connues de l'homme de l'art.

Les getters peuvent être classés en plusieurs catégories, chacune pouvant être introduite par différentes techniques : getters physiques et getters chimiques, qui eux-mêmes peuvent être séparés en deux. Les getters chimiques évaporables sont ainsi des matériaux qui sont évaporés sous vide une fois la cavité fermée et se condensent sur les parois de cette cavité dont on veut maintenir le vide. La couche ainsi formée est très réactive et forme une pompe *in situ.* Le baryum et les alliages d'aluminium/baryum sont principalement utilisés comme getters évaporables, par exemple dans les tubes cathodiques (CRT : « Cathode Ray Tube »). Une autre pompe à getter évaporable est la pompe à sublimation de titane (TSP) dans laquelle du titane ou un alliage de titane et molybdène sont sublimés et condensés sur les parois froides du corps de pompe.

Parallèlement existent des getters chimiques non évaporables ou NEG (« Non Evaporable Getter ») ; ce sont principalement des alliages à base de zirconium, vanadium, fer ou titane. Les NEG restent à l'état solide. Ils s'activent par un traitement thermique adapté, et peuvent alors adsorber et/ou absorber certains gaz, tels que H₂, CO, N₂, CO₂, O₂, ... A titre d'exemple, la société *SAES Getters* commercialise différents NEG : St122™ est un alliage à base de titane, St707™ est un alliage ZrVFe (70 % de zirconium, 24,6 % de vanadium et 5,4 % de fer), qui sont déposés par sérigraphie en fines couches sur un substrat métallique. Pour des applications MEMS, ces getters sont en général intégrés par un positionnement et un collage (technique de type « *Pick & Place* »).

A ce jour, pour le packaging des microsystèmes ou des bolomètres non refroidis, des getters NEG sont souvent utilisés ; ils peuvent être positionnés et collés dans des cavités d'accueil prévues à cet effet sur le substrat. Une autre technique est un dépôt direct en couche mince du matériau sur le capot (voir par exemple document WO 02/42716) ; le getter peut être soudé sur la couche qui sert également de cordon pour le scellement eutectique.

Dans le cas des NEG déposés en couches minces, un problème est la saturation qui se produit pendant les phases de « remise à l'air » avant ou pendant l'étape de scellement de la cavité, c'est-à-dire de non maintien de l'atmosphère contrôlée. En effet, la partie externe de la couche de sorption peut réagir pendant le temps d'exposition à l'air au cours du procédé d'encapsulation du MEMS, et donc se saturer, limitant ainsi par la suite ses performances de « getter ». Bien que le matériau getter soit susceptible de se régénérer par chauffage, il est préférable de protéger sa surface jusqu'au scellement pour éviter que l'élément de sorption ne se sature et/ou que ses performances ne soient dégradées lors du processus de fabrication du microdispositif.

Un autre problème lié à la présence d'une couche getter en surface est que cette couche peut être incompatible avec certaines techniques classiques de micro-usinage (par exemple lors de l'emploi de certaines résines, de gravures chimiques ou réactives,...), ce qui limite les choix possibles de procédés de réalisation.

Le document US 2003/0138656 propose comme solution de recouvrir le matériau getter par une couche non réactive qui joue le rôle de protection pendant les remises à l'air. Un traitement thermique ultérieur permet au matériau getter de diffuser dans la couche non réactive pour finalement tenir sa fonction de pompage. La diffusion du matériau getter dans le matériau non réactif réduit cependant ses propriétés d'absorption.

Le problème de la protection du matériau de sorption lors de son intégration à une cavité de MEMS n'est donc pas résolu.

### EXPOSÉ DE L'INVENTION

En se basant sur la compréhension des mécanismes de pompage et du comportement des getters en film mince, l'invention propose une méthode à bas coût d'intégration de ces pompes dans les microsystèmes en augmentant ainsi leur durée de vie à la pression spécifiée.

Sous un de ses aspects, l'invention concerne un procédé pour mettre en place un élément de sorption dans une cavité, notamment d'un dispositif microélectronique ou micromécanique, sous la forme d'une zone, de préférence une couche mince, par exemple entre 0,1 et 10 micromètres, en matériau getter, par exemple le titane. La cavité peut comprendre par ailleurs un composé microélectronique, ou un MEMS, ou un bolomètre, ou tout autre composant dont le fonctionnement préconise le positionnement dans une cavité à atmosphère contrôlée et à vide plus ou moins poussé.

Un élément de réaction est mis en place dans la cavité, de préférence à une distance non nulle de la couche getter, sur la même paroi, la paroi opposée, ou même en tant que cordon de scellement de la cavité. La zone de réaction peut prendre différentes configurations par rapport à l'élément de sorption : il peut former un cadre continu autour de lui, ou ne Finalement, le document US2004/0189195 décrit la protection d'un matériau getter par un matériau qui va fondre, et non réagir par déplacement avec un matériau de réaction. l'entourer que partiellement, ou comprendre différents blocs de réaction répartis autour de la zone getter, voire recouvrir partiellement cette dernière.

Par ailleurs, la zone de matériau getter est recouverte, au moins partiellement mais de préférence entièrement, par une zone de protection. Il peut s'agir d'une couche protectrice déposée, qui peut avoir une épaisseur comprise entre 0,1 et 10 micromètres ; son matériau est inerte vis-à-vis du matériau getter, c'est-à-dire qu'il est stable et non mouillant.

Le procédé selon l'invention comprend ensuite une élévation de la température de l'ensemble, lors du scellement de la cavité ou après mise sous vide, qui entraîne la réaction entre zone protectrice et élément de réaction : le matériau de protection se déplace, par « aspiration » ou « consommation », vers la zone de réaction pour s'y localiser voire s'y intégrer, de sorte que la zone de matériau getter n'est plus recouverte de la zone protectrice et reste libre, au moins partiellement. Le déplacement du matériau de protection pour retirer la zone protectrice et libérer la zone getter a lieu de préférence entre 200 et 500°C.

Le retrait de l'élément de protection se fait principalement par fusion de l'un des matériaux de protection et de réaction. Par exemple, il est possible que le matériau de réaction soit un matériau fusible, comme un alliage à base d'étain ou un alliage Au/Si, qui, lors de la montée en température, réagit avec la zone de protection, par exemple en or, argent ou platine, en la consommant pour ainsi libérer la zone getter. Le matériau de réaction fusible est de préférence solidaire d'un matériau mouillant pour rester en place et ne pas altérer le getter ou le composé actif. L'élément de réaction peut être en contact avec la zone de protection à basse température, ou uniquement lorsque la température de fusion est atteinte.

Inversement, le matériau de protection peut comprendre un matériau fusible, en particulier un alliage à base d'étain, à une température de retrait atteinte lors de l'élévation de température ; dans ce cas, l'élément de réaction est de préférence mouillant pour ce matériau, par exemple l'or, de sorte que le matériau de protection, pendant sa fusion, est attiré par le matériau de réaction pour libérer la zone getter. La zone protectrice peut par ailleurs comporter un deuxième matériau, par exemple sous forme de bicouche, entraîné par le matériau fusible lors de son déplacement.

Sous un autre aspect, l'invention concerne un dispositif issu d'un procédé décrit précédemment, à une étape intermédiaire ou finale.

### BRÈVE DESCRIPTION DES DESSINS

Les caractéristiques et avantages de l'invention seront mieux compris à la lecture de la description qui va suivre et en référence aux dessins annexés, donnés à titre illustratif et nullement limitatifs.

Les figures 1A à 1C illustrent la protection d'une couche getter selon l'invention.

Les figures 2A à 2C montrent un mode de réalisation préféré d'un procédé selon l'invention.

Les figures 3A et 3B montrent un autre mode de réalisation préféré d'un procédé selon l'invention.

La figure 4 montre un autre mode de réalisation préféré d'un procédé selon l'invention.

Les figures 5 à 7 schématisent des géométries possibles pour une protection selon l'invention, les indices A, B, C présentant les étapes de la protection à la libération du getter.

La figure 8 montre un mode alternatif de réalisation d'une protection selon l'invention.

Les figures 9A et 9B montrent un mode alternatif de réalisation de la protection selon l'invention.

### EXPOSÉ DÉTAILLÉ DE MODES DE RÉALISATION PARTICULIERS

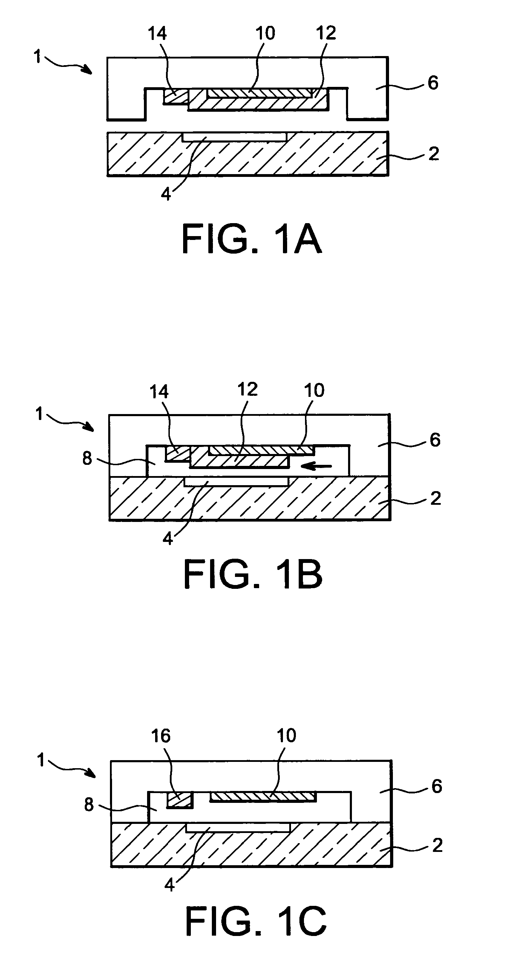

Tel qu'il est usuel avant l'encapsulation, un microdispositif 1, schématisé en figure 1A, comprend un substrat 2, par exemple en matériau semi-conducteur comme le silicium, sur lequel peut être localisé un composé actif 4. Un capot 6, par exemple en verre ou en matériau semi-conducteur, présentant un évidement permet, par report du capot 6 sur le substrat 2, de créer une cavité 8 dans laquelle peut se loger le composé actif 4 ; cette cavité a des dimensions allant de 1 mm² à quelques cm²; le composé actif 4 peut être un système micromécanique de type capteur pouvant comporter des éléments suspendus (accéléromètre, gyromètre, bolomètre,...). Il est clair que le composé 4 peut se situer dans le capot 6, ou que le capot peut être rapporté par différentes techniques sur le substrat 2. Par exemple, le capot 6 peut également être plan, sans évidement, et la cavité 8 être créée par des cordons de soudure rapportés. Le substrat 2 peut également avoir été évidé.

La cavité 8 loge en outre un matériau getter 10. Le matériau getter peut comprendre un alliage à base de Zr, V, Fe, Ti, ou bien une zone métallique à base de Ba, Mo, Mg, Al, Th, Ti, Zr, Va, Fe, Pd, ou tout autre matériau ayant des propriétés d'absorption. De préférence, il s'agit de titane dont les capacités de sorption sont élevées.

Le matériau getter est disposé de préférence sous forme d'une couche, avantageusement un film mince, d'épaisseur comprise entre 100 nm et 10 µm, qui a par exemple été évaporée ou pulvérisée sous vide ; dans ce cas de pulvérisation, les procédés sont aménagés pour réduire la quantité de gaz neutre incorporé pendant le dépôt et susceptible d'être relâché dans la cavité 8 lors de l'étape thermique. Selon un mode de réalisation usuel illustré, la couche de matériau getter 10 est déposée sur la paroi de la cavité 8 faisant face à la paroi comprenant la zone active 4, c'est-à-dire dans ce cas dans le capot 6, mais il est clair que des alternatives sont possibles, avec par exemple un film 10 adjacent au composé 4, voire disposé sur une partie du composé 4, par exemple sur les éléments en suspension d'un accéléromètre, etc.

Lors du report du capot 6 sur le substrat 2, il est difficile de maintenir le vide utilisé lors du dépôt de la couche getter 10. Afin de réaliser une protection du getter 10 et éviter ainsi sa saturation avant même la mise sous atmosphère contrôlée de la cavité 8, le film getter 10 est recouvert par un matériau de protection 12. La couche de matériau de protection 12 peut recouvrir partiellement le matériau getter mais, avantageusement, elle le recouvre totalement, c'est-à-dire que la couche de protection 12 est de surface supérieure à la surface du matériau getter 10 et l'englobe. Avantageusement, la couche de protection 12 pourra être déposée *in situ* sur la couche de matériau getter 10, c'est-à-dire dans l'équipement de dépôt du matériau getter sans rupture de vide.

La couche de protection 12 pourra être déposée en une ou plusieurs fois. Ainsi par exemple, pour localiser la couche getter 10, on pourra procéder à une étape de gravure de l'empilement couche getter - couche de protection ; il pourra être utile, après gravure, de procéder à un nouveau dépôt protecteur 12 pour protéger les zones getter mises à nu au niveau des flancs de gravures.

Le matériau de protection 12 est choisi de façon à ne pas interagir avec le matériau getter 10 ; en particulier, la zone protectrice 12 est stable et capable de bien enrober le matériau getter de façon à le protéger. Son épaisseur dépend de sa nature, mais de préférence reste mince, de l'ordre de 0,1 à 1 µm pour pouvoir être retirée complètement.

Le matériau de protection est par ailleurs choisi pour ses propriétés réactionnelles au cours d'un traitement thermique. En particulier, lors d'une élévation en température de la cavité 8 permettant d'atteindre ou dépasser une température de retrait, le matériau de protection 12 est capable de libérer la surface du getter 10 en réagissant avec un matériau de réaction 14 qui le déplace physiquement. La montée en température s'effectue alors que le vide peut être installé et maintenu dans la cavité 8, pendant ou après le scellement de la cavité 8.

Tel qu'illustré sur la figure 1, le matériau de protection 12 est ainsi en contact avec une zone de réaction 14. A la température de retrait ou au-delà, le matériau de réaction 14 « aspire » le matériau de protection 12, par fluage ou consommation tel qu'il sera précisé plus loin : figure 1B. Il est avantageux que la couche protectrice 12 et le matériau réactif 14 ne mouillent pas bien sur le matériau getter 10 ; ceci favorise également l'utilisation de titane comme matériau getter car Ti est non mouillant pour beaucoup d'alliages.

La couche de protection 12 libère donc progressivement la couche getter 10, pour aboutir à un microdispositif 1 selon la figure 1C, dans lequel une couche getter libre 10 fait face à la zone active 4 au sein d'une cavité 8, dans laquelle règne un vide plus ou moins poussé, et comprenant un élément 16 dont la composition est un mélange plus ou moins homogène des matériaux de réaction 14 et de protection 12.

Pour déplacer le matériau de protection, et donc retirer la couche protectrice 12, différentes solutions sont envisageables.

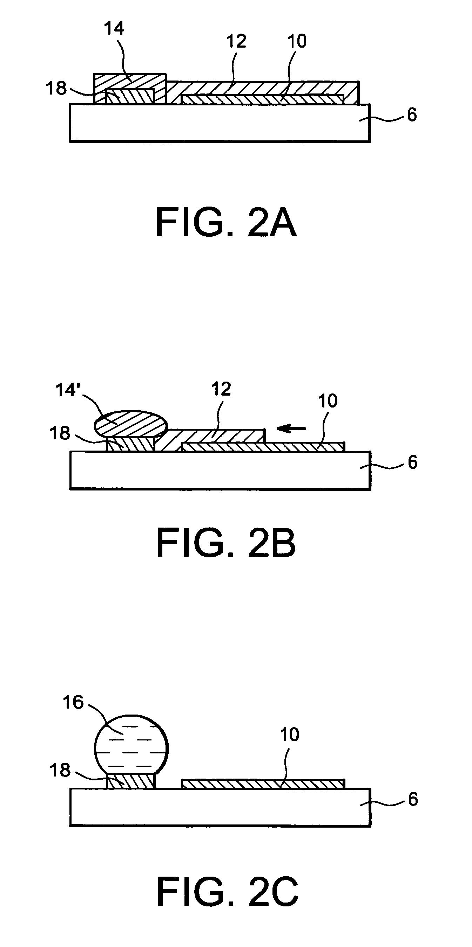

En particulier, tel que schématisé dans les figures 2, il est possible que la couche protectrice 12 soit consommée par un matériau en fusion localement :
lors de la montée en température, le matériau de réaction 14, fusible à la température de retrait, se déforme afin de créer une goutte 14' (figure 2B). Selon la nature du matériau en fusion, la goutte 14' peut attirer un matériau en contact avec elle, par exemple la couche de protection 12. La couche de protection 12 est donc agencée pour être proche de l'élément de réaction 14 et pour être en contact avec lui lorsqu'il est sous forme de goutte ; de préférence, elle lui est adjacente même à température inférieure à la température de fusion du matériau de réaction.

Il existe beaucoup de couples possibles pour la couche protectrice 12 et le matériau réactif 14. En particulier, les métaux précieux tels que Au, Ag ou Pt sont des bons candidats en tant que matériaux de protection 12 : ils peuvent être déposés en couche mince, ils sont très stables et ils sont très facilement consommés par des alliages de réaction 14, notamment un alliage Au/Si ou un alliage à base d'étain, par exemple Sn/Bi, Sn/Pb In/Sn, Sn/Pb, Sn/Pb/Ag, Sn/Ag.... Toutefois, la couche protectrice 12 peut être réalisée dans tout autre matériau moins noble s'il existe un matériau ou alliage réactif qui puisse l'absorber : par exemple le cuivre peut être utilisé, ou l'aluminium, ou encore Al/Au/Si.

Dans ce cas où le matériau de réaction 14 est fusible, il peut s'avérer préférable d'avoir préalablement défini une zone mouillante 18 sur laquelle l'élément réactif 14 est mis en place : au moment de la fusion et pendant la consommation de la couche protectrice 12, la goutte 14' de matériau de réaction reste en place, à l'écart du matériau getter 10. L'or est le matériau mouillant 18 le plus utilisé ; il est généralement déposé en tricouche Ti/Ni/Au ou Ti/Pd/Au, le titane servant de couche d'accroche et le nickel ou le palladium servant de barrière de diffusion.

A titre d'exemple pour un élément tel qu'illustré en figure 2A, une couche 10 de titane de 100 nm à 10 µm est déposée sous vide (par évaporation ou pulvérisation), puis recouverte par dépôt d'une couche 12 d'or sous vide (par évaporation ou pulvérisation) d'épaisseur typique de 100 nm à 1 µm, avant remise à l'air. Suivant le mode de réalisation, il peut y avoir la création de motifs (« patterning ») pour définir la localisation de la zone getter ; ces motifs peuvent être réalisés par des procédés classiques de microélectronique, notamment des étapes de dépôt, photolithographie, gravure,.... Le matériau mouillant 18 est ensuite mis en place, par dépôts successifs de Ti (couche d'accroche), Ni (barrière de diffusion) et Au (couche mouillante), par exemple par évaporation, pulvérisation ou électrodéposition, chacune des monocouches faisant typiquement de 0,1 à 1 µm ; selon le cas, il peut y avoir également patterning du matériau mouillant. Sur le matériau mouillant 18 est déposée (évaporation, pulvérisation, électrodéposition) une couche 14 d'alliage eutectique Au/Sn (80/20 %), d'épaisseur de l'ordre de 100 nm à 10 µm ; il peut y avoir également création de motifs.

Dans cet exemple, les conditions d'absorption de la couche protectrice 12 par le matériau réactif 14 sont un recuit au-delà de 280°C pendant quelques secondes à quelques minutes pour passer du composé schématisé à la figure 2A à celui de la figure 2C. Il est naturellement envisageable de mettre en place la couche mouillante 18, voire le matériau réactif 14, avant la couche getter 10 et/ou la couche protectrice 12.

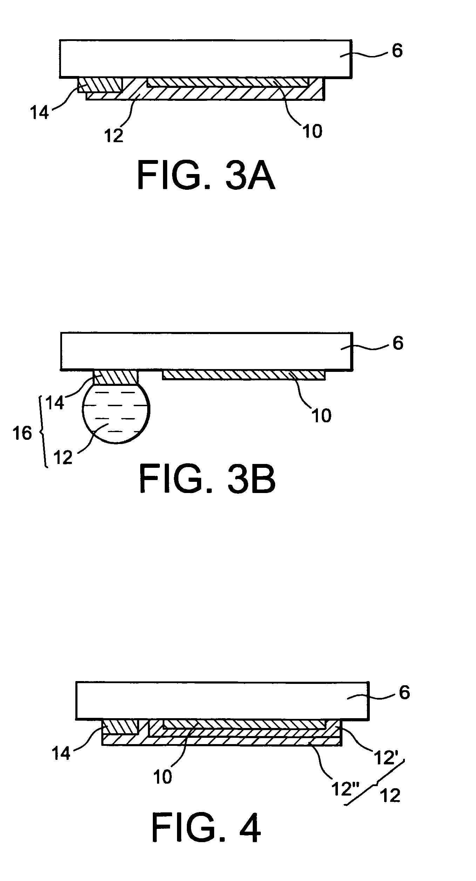

Tel qu'illustré sur les figures 3, il est possible que le matériau protecteur 12 lui-même soit fusible à la température de retrait : la couche protectrice 12 se déplace grâce à la tension de surface vers des zones réactives mouillantes 14 préalablement définies. Ici encore, il existe beaucoup de couples alliage fusible/couche mouillante possibles. A titre d'exemples, les alliages 12 Sn/Pb ou Sn/Ag sont particulièrement indiqués, car ils ne mouillent pas sur la plupart des matériaux utilisés en tant que getters 10, et en particulier le titane, mais mouillent très bien sur un matériau 14 tel que l'or. Le matériau réactif mouillant 14 est généralement déposé en tricouche Ti/Ni/Au ou Ti/Pd/Au tel que précisé plus haut.

Un exemple de réalisation d'un dispositif selon la figure 3A comprend une couche 10 de titane de 100 nm à 10 µm déposée sous vide (par évaporation ou pulvérisation) ; suivant le mode de réalisation, il peut y avoir la création de motifs (« patterning »). Le matériau mouillant 14 de réaction est ensuite, ou auparavant, mis en place, par dépôts successifs de Ti (couche d'accroche), Ni (barrière de diffusion) et Au (couche mouillante), par exemple par évaporation, pulvérisation ou électrodéposition, chacune des monocouches faisant typiquement de 0,1 à 1 µm ; selon le motif choisi, il peut y avoir également patterning du matériau mouillant 14. Les deux éléments 10, 14 sont recouverts par dépôt d'une couche 12 de l'alliage Sn/Ag (96,5/3,5 %) sous vide (par évaporation ou pulvérisation) d'épaisseur typique de 100 nm à 1 µm, avant remise à l'air

Dans cet exemple, les conditions d'adsorption de la couche protectrice 12 par le matériau réactif 14 pour former le matériau hétérogène 16 illustré en figure 3B sont un recuit au-delà de 200°C pendant quelques secondes à quelques minutes.

La couche protectrice 12 peut par ailleurs être composée à la fois d'une couche 12' jouant le rôle de protection « inerte » consommable, comme l'or, et d'un matériau fusible 12", comme illustré sur la figure 4 : l'élément de réaction 14 comprend alors un matériau mouillant, et la montée en température fait fluer le matériau fusible 12" de la couche de protection 12 vers les zones mouillantes 14, tout en consommant la couche inerte 12'. D'autres géométries sont possibles.

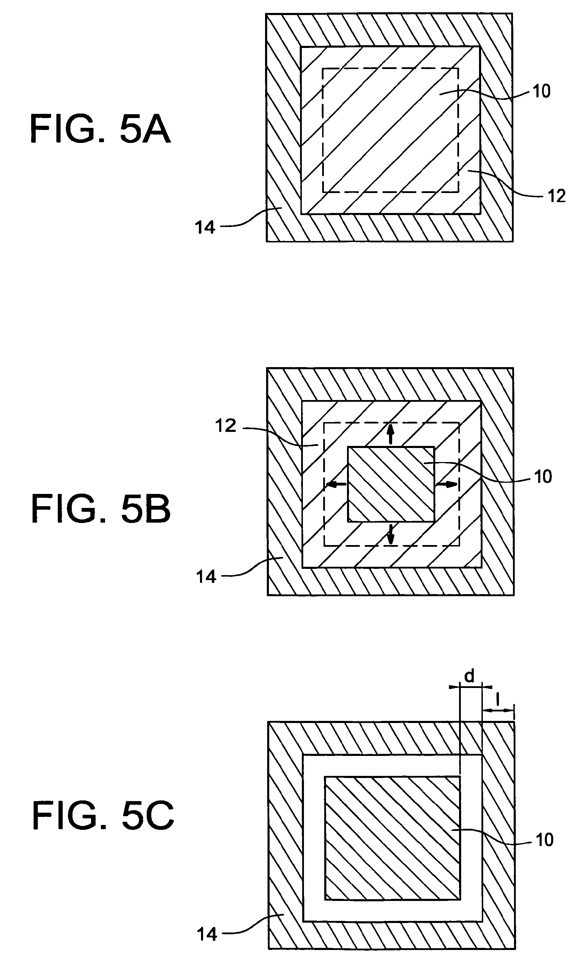

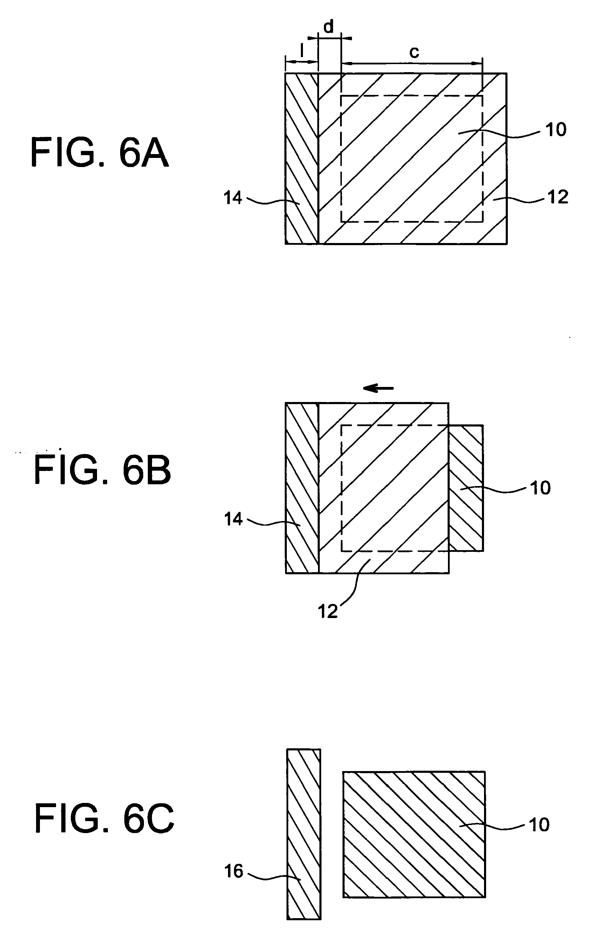

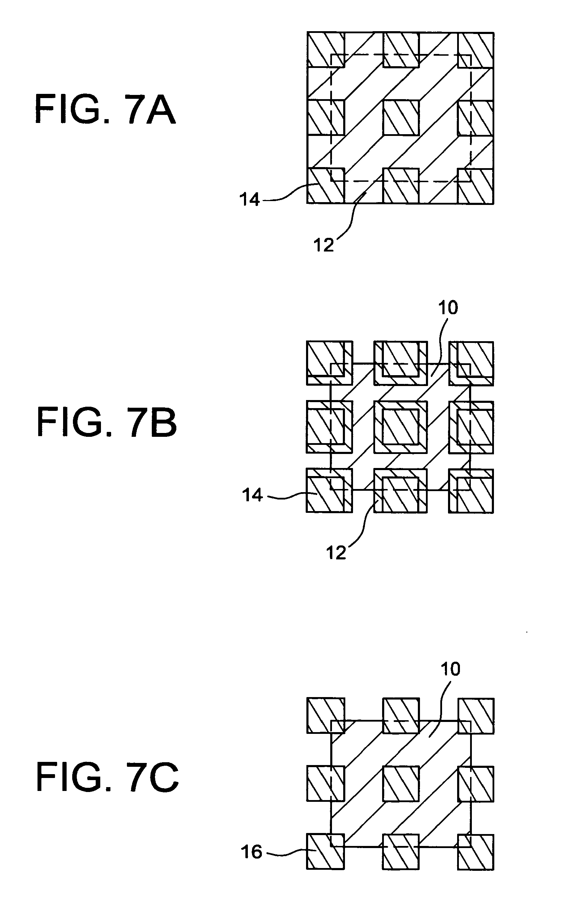

L'élément de réaction 14 a été présenté comme positionné sur un côté de la couche getter 10. De fait, de nombreuses configurations sont possibles, tel qu'illustré sur les figures 5, 6 et 7 : dans le cadre représenté, le matériau getter 10 forme un film de côtés c compris entre 50 µm et 1 cm ; la couche de protection 12 recouvre totalement le film getter 10 et le dépasse sur chaque côté ; le matériau de réaction 14 se présente sous la forme d'une bande de largeur l de l'ordre de 10 µm à 1 mm, séparée du film getter d'une distance d de l'ordre de quelques microns ; en variante, si le matériau de réaction ne réagit pas avec le matériau getter 10, il peut lui être adjacent, voire le chevaucher (figure 7). Le matériau de réaction 14 peut entourer totalement le film getter 10 (figure 5) ou partiellement (figure 6) ou être disposé sous forme de réseau ajouré (figure 7). Les étapes A, B, C reprennent les étapes de la figure 1 et illustrent la libération du film getter 10 et le déplacement du matériau de protection 12. Bien entendu, d'autres configurations sont possibles, suivant la taille et la nature de la zone getter 10, la température de retrait atteinte, et la vitesse de réaction pour le retrait entre autres.

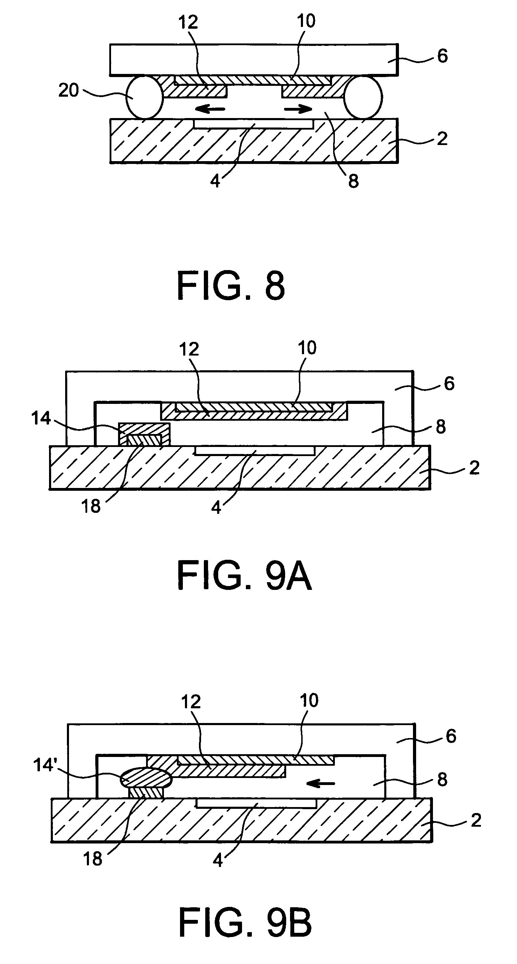

Un exemple particulier, illustré en figure 8, concerne un matériau de réaction 14 qui sert également de cordon de scellement 20 de la cavité 8 pour un scellement eutectique : un cordon 20 en Au/Si ou en Sn/Pb ou en Sn/Ag est chauffé une fois le capot 6 rapporté sur le substrat 2 afin d'assurer l'étanchéité de la cavité 8 ; en même temps, il peut consommer une couche 12 d'or préalablement déposée pour protéger le matériau getter 10.

Par ailleurs, en particulier dans le cas où la couche protectrice 12 est consommée par un matériau réactif 14 en fusion, il est également envisageable de positionner l'élément de réaction 14 sur la paroi de la cavité 8 opposée au matériau getter 10 revêtu de sa couche de protection 12, en particulier sur le substrat 2 : voir figure 9A. Il est préférable de mettre en place le matériau de réaction 14 (par exemple Au/Si, Sn/Pb ou Sn/Ag) sur une zone mouillante 18 pour éviter de polluer la zone active 4 ; il est préférable également que cette zone mouillante 18 soit de taille restreinte de façon à ce que le matériau réactif 14 en fusion, qui forme une goutte 14' sur la zone mouillante 18, se concentre à ce niveau et vienne au contact de la couche protectrice 12 (par exemple en or) et la consomme (figure 9B). De préférence, les deux éléments 12, 14 ne sont pas en contact à température ambiante, et ne deviennent adjacents que lorsque la température de fusion est atteinte ou dépassée.

Le procédé selon l'invention est particulièrement facile à mettre en oeuvre, et ne nécessite pas de modification coûteuse des technologies d'encapsulation. En particulier, le retrait de la couche de protection peut être effectué en parallèle du scellement de la cavité, et s'accompagne habituellement d'une régénération du matériau getter par l'élévation de la température. Le procédé permet l'utilisation de films minces déposés directement sur une surface de la cavité, voire sur plusieurs surfaces si nécessaire, en optimisant la quantité de matériau getter.

## Revendications

1. Procédé de mise en place d'un élément de sorption (10) dans une cavité (8) comprenant :
- la réalisation, à l'intérieur de la cavité (8), d'une zone en matériau getter (10), d'une zone en matériau de réaction (14) et d'une zone protectrice (12) en matériau de protection, la zone protectrice (12) recouvrant au moins une partie de la zone en matériau getter (10) de façon à enterrer ladite partie ;
- une élévation de la température jusqu'à au moins une température de retrait ;
- le déplacement du matériau de protection de la zone protectrice (12) vers la zone de réaction (14) par réaction entre le matériau de protection (12) et le matériau de réaction (14) de façon à ce que au moins une portion de ladite partie de la zone en matériau getter (10) ne soit plus recouverte de matériau de protection.

2. Procédé selon la revendication 1 dans lequel la zone de matériau getter est réalisée sous forme d'une couche mince (10) d'épaisseur comprise entre 100 nm et 10 µm.

3. Procédé selon l'une des revendications 1 à 2 dans lequel la zone protectrice (12) est réalisée sous forme d'une couche mince d'épaisseur comprise entre 100 nm et 10 µm et recouvre entièrement la zone de matériau getter (10).

4. Procédé selon l'une des revendications 1 à 3 dans lequel le matériau de protection est stable et non mouillant vis-à-vis du matériau getter.

5. Procédé selon l'une des revendications 1 à 4 dans lequel le matériau getter est du titane.

6. Procédé selon l'une des revendications 1 à 5 dans lequel la température de retrait est de l'ordre de 200 à 500°C.

7. Procédé selon l'une des revendications 1 à 6 dans lequel le matériau de réaction (14) est un matériau fusible à la température de retrait.

8. Procédé selon la revendication 7 dans lequel la zone de réaction (14) est positionnée au moins partiellement sur un matériau mouillant (18) pour le matériau de réaction.

9. Procédé selon l'une des revendications 7 ou 8 dans lequel le matériau de protection (12) est choisi parmi Au, Ag et Pt, et le matériau de réaction (14) est choisi parmi un alliage Au/Si ou les alliages à base d'étain.

10. Procédé selon l'une des revendications 1 à 6 dans lequel le matériau de protection (12) comprend un matériau fusible à la température de retrait.

11. Procédé selon la revendication 10 dans lequel le matériau de réaction (14) est un matériau mouillant pour le matériau de protection (12) fusible.

12. Procédé selon l'une des revendications 10 ou 11 dans lequel le matériau de protection (12) est choisi parmi les alliages à base d'étain, comme Sn/Pb, Sn/Ag et Sn/Au, et le matériau de réaction (14) est l'or.

13. Procédé selon l'une des revendications 1 à 12 dans lequel la zone de réaction (14) est positionnée sur la même paroi de la cavité (8) que la zone de matériau getter (10).

14. Procédé selon l'une des revendications 1 à 12 dans lequel la zone de réaction (14) est placée sur une paroi de la cavité (8) opposée à la paroi supportant la zone de matériau getter (10).

15. Procédé selon l'une des revendications 1 à 14 dans lequel la zone de réaction (14) est sous forme d'un anneau encadrant la zone de matériau getter (10).

16. Procédé selon l'une des revendications 1 à 14 dans lequel la zone de réaction (14) comprend plusieurs blocs de réaction disposés sous forme de réseau au niveau de la zone de matériau getter (10).

17. Procédé selon l'une des revendications 1 à 12 dans lequel la zone de réaction (14) est constitutive d'une paroi (20) au moins de la cavité (8).

18. Procédé selon l'une des revendications 1 à 17 comprenant en outre une étape de scellement de la cavité (8) avant ou pendant l'élévation de température.

19. Procédé selon l'une des revendications 1 à 18 dans lequel la cavité (8) comprend en outre un microsystème (4).

20. Dispositif microélectronique (1) comprenant une cavité (8) dans laquelle sont positionnées une zone de réaction (14) contenant un matériau de réaction et une zone contenant un matériau getter (10), le matériau getter (10) étant revêtu, au moins partiellement, d'un matériau de protection (12) qui est apte à réagir thermiquement avec le matériau de réaction, cette réaction thermique générant un déplacement de matériau de protection (12).

## Claims

1. Method for installing a sorption element (10) in a cavity (8) comprising:
- the formation, within the cavity (8), of a getter material zone (10), a reaction material zone (14) and a protective material protective zone (12), said protective zone (12) covering at least one part of the getter material zone (10) so as to bury said part;
- raising the temperature up to at least one removal temperature;
- moving the protective material from the protective zone (12) towards the reaction zone (14) so that at least one portion of said part of the getter material zone (10) is no longer covered with protective material.

2. Method according to claim 1 wherein the getter material zone is produced in the form of a thin film (10) of thickness between 100 nm and 10 µm.

3. Method according to one of claims 1 to 2 wherein the protective zone (12) is produced in the form of a thin film of thickness between 100 nm and 10 µm and entirely covers the getter material zone (10).

4. Method according to one of claims 1 to 3 wherein the protective material is stable and non wetting vis-à-vis the getter material.

5. Method according to one of claims 1 to 4 wherein the getter material is titanium.

6. Method according to one of claims 1 to 5 wherein the removal temperature is around 200 to 500°C.

7. Method according to one of claims 1 to 6 wherein the reaction material (14) is a fusible material at the removal temperature.

8. Method according to claim 7 wherein the reaction zone (14) is positioned at least partially on a wetting material (18) for the reaction material.

9. Method according to one of claims 7 or 8 wherein the protective material (12) is chosen among Au, Ag and Pt, and the reaction material (14) is chosen among an Au/Si alloy or alloys based on tin.

10. Method according to one of claims 1 to 6 wherein the protective material (12) comprises a material that melts at the removal temperature.

11. Method according to claim 10 wherein the reaction material (14) is a wetting material for the fusible protective material (12).

12. Method according to one of claims 10 or 11 wherein the protective material (12) is chosen among alloys based on tin, such as Sn/Pb, Sn/Ag and Sn/Au, and the reaction material (14) is gold.

13. Method according to one of claims 1 to 12 wherein the reaction zone (14) is positioned on the same wall of the cavity (8) as the getter material zone (10).

14. Method according to one of claims 1 to 12 wherein the reaction zone (14) is placed on a wall of the cavity (8) opposite the wall bearing the getter material zone (10).

15. Method according to one of claims 1 to 14 wherein the reaction zone (14) is in the form of a ring framing the getter material zone (10).

16. Method according to one of claims 1 to 14 wherein the reaction zone (14) comprises several reaction blocks arranged in network form at the level of the getter material zone (10).

17. Method according to one of claims 1 to 12 wherein the reaction zone (14) constitutes at least one wall (20) of the cavity (8).

18. Method according to one of claims 1 to 17 further comprising a step of sealing of the cavity (8) before or during the raising of temperature.

19. Method according to one of claims 1 to 18 wherein the cavity (8) moreover comprises a microsystem (4).

20. Microelectronic device (1) comprising a cavity (8) in which are positioned a reaction zone (14) comprising a reaction material and a zone (10) comprising a getter material, the getter material being covered, at least partially, by a protective material (12) that is capable of heat reacting with the reaction material, said heat reaction generating a moving of the protective material (12).

## Patentansprüche

1. Verfahren zum Anbringen eines Sorptionselements (10) in einem Hohlraum (8), das Folgendes umfasst:
- bilden innerhalb des Hohlraums (8) einer Gettermaterialzone (10), einer Reaktionsmaterialzone (14) und einer Schutzzone (12) aus Schutzmaterial, wobei die Schutzzone (12) wenigstens einen Teil der Gettermaterialzone (10) so bedeckt, dass dieser Teil verdeckt ist,
- eine Temperaturerhöhung bis mindestens zu einer Entfernungstemperatur,
- bewegen des Schutzmaterials der Schutzzone (12) zur Reaktionszone (14) durch Reaktion zwischen dem Schutzmaterial (12) und dem Reaktionsmaterial (14), so dass wenigstens ein Abschnitt dieses Teils der Gettermaterialzone (10) nicht mehr mit Schutzmaterial bedeckt ist.

2. Verfahren gemäß Anspruch 1, wobei die Gettermaterialzone in Form einer dünnen Schicht (10) mit einer Dicke zwischen 100 nm und 10 µm ausgeführt ist.

3. Verfahren gemäß einem der Ansprüche 1 bis 2, wobei die Schutzzone (12) in Form einer dünnen Schicht mit einer Dicke zwischen 100 nm und 10 µm ausgeführt ist und die Gettermaterialzone (10) vollständig bedeckt.

4. Verfahren gemäß einem der Ansprüche 1 bis 3, wobei das Schutzmaterial gegenüber dem Gettermaterial stabil und nichtbenetzend ist.

5. Verfahren gemäß einem der Ansprüche 1 bis 4, wobei das Gettermaterial Titan ist.

6. Verfahren gemäß einem der Ansprüche 1 bis 5, wobei die Entfernungstemperatur in der Größenordnung von 200 bis 500 °C liegt.

7. Verfahren gemäß einem der Ansprüche 1 bis 6, wobei das Reaktionsmaterial (14) ein bei der Entfernungstemperatur schmelzendes Material ist.

8. Verfahren gemäß Anspruch 7, wobei sich die Reaktionszone (14) mindestens zum Teil auf einem Benetzungsmaterial (18) für das Reaktionsmaterial befindet.

9. Verfahren gemäß einem der Ansprüche 7 oder 8, wobei das Schutzmaterial (12) aus Au, Ag und Pt ausgewählt ist und das Reaktionsmaterial (14) aus einer Au/Si-Legierung oder Legierungen auf Zinngrundlage ausgewählt ist.

10. Verfahren gemäß einem der Ansprüche 1 bis 6, wobei das Schutzmaterial (12) ein bei der Entfernungstemperatur schmelzendes Material umfasst.

11. Verfahren gemäß Anspruch 10, wobei das Reaktionsmaterial (14) ein Benetzungsmaterial für das schmelzbare Schutzmaterial (12) ist.

12. Verfahren gemäß einem der Ansprüche 10 oder 11, wobei das Schutzmaterial (12) aus Legierungen auf Zinngrundlage wie Sn/Pb, Sn/Ag und Sn/Au ausgewählt ist und das Reaktionsmaterial (14) Gold ist.

13. Verfahren gemäß einem der Ansprüche 1 bis 12, wobei sich die Reaktionszone (14) auf derselben Wand des Hohlraums (8) wie die Gettermaterialzone (10) befindet.

14. Verfahren gemäß einem der Ansprüche 1 bis 12, wobei sich die Reaktionszone (14) auf einer Wand des Hohlraums (8) befindet, die der die Gettermaterialzone (10) tragenden Wand gegenüberliegt.

15. Verfahren gemäß einem der Ansprüche 1 bis 14, wobei die Reaktionszone (14) die Form eines die Gettermaterialzone (10) einrahmenden Rings aufweist.

16. Verfahren gemäß einem der Ansprüche 1 bis 14, wobei die Reaktionszone (14) mehrere in Form eines Netzwerks auf der Gettermaterialzone (10) angeordnete Reaktionsblöcke umfasst.

17. Verfahren gemäß einem der Ansprüche 1 bis 12, wobei die Reaktionszone (14) wenigstens eine Wand (20) des Hohlraums (8) darstellt.

18. Verfahren gemäß einem der Ansprüche 1 bis 17, das außerdem einen Schritt des Versiegelns des Hohlraums (8) vor oder während der Temperaturerhöhung umfasst.

19. Verfahren gemäß einem der Ansprüche 1 bis 18, wobei der Hohlraum (8) außerdem ein Mikrosystem (4) umfasst.

20. Mikroelektronisches Bauteil (1) umfassend einen Hohlraum (8), in dem sich eine ein Reaktionsmaterial enthaltende Reaktionszone (14) und eine ein Gettermaterial (10) enthaltende Zone befinden, wobei das Gettermaterial (10) mindestens zum Teil mit einem Schutzmaterial (12) bedeckt ist, das mit dem Reaktionsmaterial thermisch reagieren zu vermag, wobei diese thermische Reaktion eine Bewegung des Schutzmaterial (12) erzeugt.
